# EUROPEAN PATENT SPECIFICATION

(11) **EP 2 434 644 B1**
(45) Date of publication and mention of the grant of the patent: **11.11.2015**
(21) Application number: 10180189.2
(22) Date of filing: 27.09.2010
(51) Int. Cl.: H03K 17/0412, H03K 17/691

(54) **High voltage floating gate driver topology for very high switching frequencies**
Hochspannungs-Floating-Gate-Treibertopologie für sehr hohe Schaltfrequenzen
Topologie de commande de grille flottante haute tension pour fréquences de commutation très élevées

(43) Date of publication of application: 28.03.2012
(73) Proprietor: Delphi Technologies, Inc., Troy, MI 48007 (US)
(72) Inventor: Sokal, Nathan, Auburndale, MA 02466-2660 (US); Redl, Richard, 1726 Farvagny-le-Petit (CH); Heise, Volker, 54292 Trier (DE)
(74) Representative: Delphi France SAS

(56) References cited:
- EP-A1- 0 578 555
- DE-A1- 3 231 788
- JP-A- 2001 305 114
- US-A- 4 527 228
- US-A- 5 168 182
- US-A1- 2007 025 123
- BALOGH L: "Design and application guide for high speed MOSFET gate drive circuits", INTERNET CITATION, 1 January 2001 (2001-01-01), pages 1-37, XP002552367, Retrieved from the Internet: URL:http://focus.ti.com/lit/ml/slup169/slu p169.pdf [retrieved on 2009-10-26]

## Description

### TECHNICAL FIELD

The present invention generally relates to a driver for switching a transistor half bridge or full bridge amplifier and more specifically a driver topology for a high voltage floating gate-source of a "half- or full bridge" switching amplifier. Such driver topology is particularly used for power supply of a high frequency ignition system in automotive vehicle. This bridge driver topology can be used in any half or full bridge application for example: high pressure discharge lamps, lightning power supplies, and so on.

### BACKGROUND OF THE INVENTION

During the endeavor of developing a robust power supply for a high frequency ignition system, it was found that switching amplifiers like class-E or class-D are promisingly suitable and efficient for sourcing the high frequency power loads.

Class-D amplifier or switching amplifier is an electronic amplifier where all power devices (usually MOSFETs) are operated as binary switches. They are either fully on or fully off. Ideally, zero time is spent transitioning between those two states. Output stages such as those used in pulse generators are examples of class D amplifiers. However, the term mostly applies to power amplifiers intended to reproduce signals with a bandwidth well below the switching frequency.

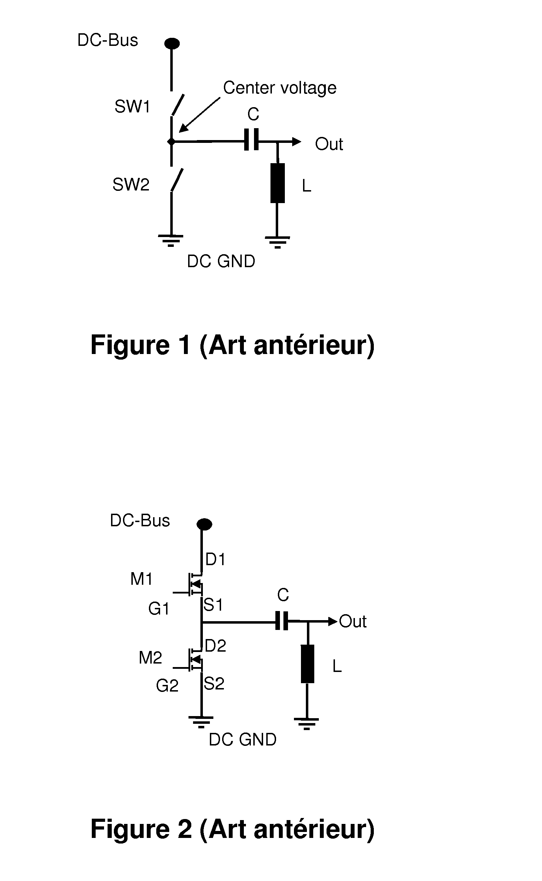

The generic class-D amplifier operation uses typically following totem pole configuration as represented in Figure 1. Two switches SW1 and SW2 are turned on and off in a very controlled manner such that an alternating current and voltage is delivered at the output OUT. It is to note that the center voltage between the switch SW1 and the switch SW2 is alternating with the acting of the switches. In case switch SW2 is turned "ON" and switch SW1 is turned "OFF" the center-voltage is then grounded and if the switch SW1 is turned "ON" and switch SW2 is turned "OFF" the center voltage reaches the DC-Bus supply voltage (see Solid State Radio Engineering, Herbert Krauss 1979).

Typical implementation for switching elements is suitable MOSFET transistor of the n-channel type, like it is represented in Figure 2. N-channel MOSFETs are turned on and off by applying defined positive gate-source voltages (gate positive). If n-channel MOSFET switches are used to realize the switch SW1 of Figure 1, then the gate and source voltage of transistor M1 requires special attention to remain within the operating limits of the device itself. The source potential of the transistor M1 is not constant, because of the alternating nature of the class-D center voltage.

The application note from IR "International Rectifier" AN-978.pdf is describing the technical challenge quite well. Available circuit's topologies to drive an n-channel MOSFET in a bridge configuration (such as represented in Figure 2) are:
a) Floating Gate Drive supply
b) Pulse transformer
c) Charge Pump
d) Bootstrap
e) Carrier Drive

None of the abovementioned structures is practically applicable for low cost high frequencies high power amplifiers, for instance of 27MHz. These known topologies require several additional components and additional supply voltages to efficiently switch a switching amplifier as shown in Figures 1 and 2

BALOGH L: "Design and application guide for high speed MOSFET gate drive circuits", 1 January 2001 (2001-01-01), pages 1-37, discloses, as shown in Fig.33 and Fig.35, gate drive transformer circuits to drive high side switches in high voltage circuits.

### SUMMARY OF THE INVENTION

One goal of the present invention is to overcome the aforecited drawbacks by providing a driver topology suitable for high frequency switching of a high voltage floating gate in a bridge configuration switching amplifier.

For that purpose, according to a first aspect, the invention concerns a driver topology for switching on and off a high voltage floating gate-source of a switching amplifier, wherein it comprises a grounded driving amplifier supplying decoupling means in series with a common mode transformer connected at its output a rectifying and stabilizing means which are in turn directly connected to the high voltage gate-source of the switching amplifier. Such driver topology allows switching on and off said switching amplifier such as power transistor at high frequencies without needing any additional supply voltages, thanks to the use of a simple passive DC to AC decoupling means and thereafter a passive transformer transmitting the energy received from the decoupling means to the next stage while blocking the reverse flow.

According to an advantageous embodiment, it further comprises a half DC-bus voltage connected to the input of the current mode transformer.

According to another advantageous embodiment, the common mode transformer is implemented by a current mode 1:1 balun or a transmission line.

According to another advantageous embodiment, the switching amplifier has a totem-pole configuration of two switches, the high voltage floating gate-source being representative of the high side, and wherein the low side driver topology comprises similar signal delay means as the high side driver topology. According to an advantageous variant, the low side driver topology comprises a grounded driving amplifier supplying a common mode transformer connected at its output to rectifying and stabilizing means which are in turn directly connected to the low side of the switching amplifier. Such replication of the driver topology on the lower side allows to adjust time delay between the upper and lower switching elements of the switching amplifier.

According to another aspect, the present invention concerns a high integrated circuit including both the driver topology according to the first aspect and the switching amplifier. Therefore, it can be higher integrated into power modules.

According to another aspect, the present invention concerns a high frequency ignition system comprising a switching amplifier and a driver topology according to the first aspect.

### BRIEF DESCRIPTION OF THE DRAWINGS

Other features and advantages of the invention will appear upon reading the following description which refers to the annexed drawings in which:
- Figure 1, already described, shows a totem pole configuration of a class-D switching amplifier;
- Figure 2, already described, shows a class-D switching amplifier implemented with MOSFETs transistors;
- Figure 3 shows a driver topology according to a first embodiment of the present invention;
- Figure 4 shows a driver topology according to another embodiment of the present invention.

### DETAILED DESCRIPTION OF THE INVENTION

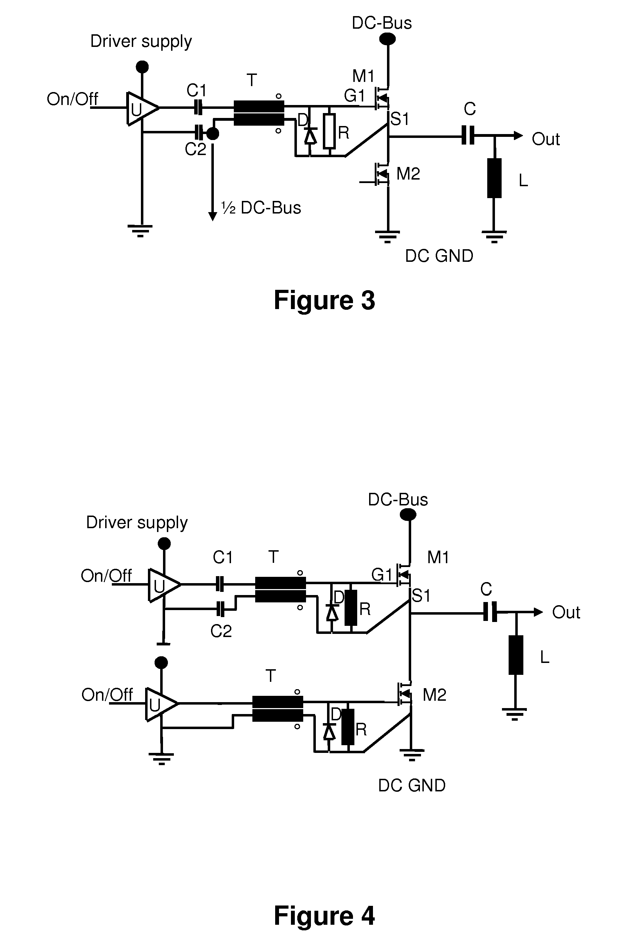

With reference now to Figure 3, it shows a driver topology according to a first embodiment of the present invention. The proposed driver topology uses on the high voltage side M1 a grounded driving amplifier U. The output of the grounded amplifier U is decoupled from the direct current bus DC-bus with capacitors C1, C2, seen as a passive DC to AC decoupling means, and thereafter transmitted to the gate source voltage through the means of a common mode transformer T. The feature of this transformer T in this topology is that at one end it transmits the energy coming from the capacitors C1/C2 to a rectifying diode D and a stabilizing resistance R; and at the other end, it blocks the reverse flow.

With such passive topology, no intermediate energy storage is required and no additional voltage is needed. At the gate-source (G1-S1), this drive signal is rectified with the diode D and stabilised with the resistor R. Preferably, capacitor C2 requires at the transformer T connection half of the DC-Bus voltage, which can be realized by a resistor divider (not shown). Further, as it will be shown in relation with Figure 4, means for generating a delay may be provided at the lower side to transistor M2.

Figure 4 shows a driver topology according to a preferred embodiment of the present invention. It shows the duplication of the driver topology of the transistor M1 applied to the transistor M2. This allows generating a similar signal delay as created by the high side drive of M1. Nevertheless, it is understood that this delay can be generated by any upfront logic circuitry instead of using such duplication. Furthermore, it is to be noticed that capacitors C1 and C2 used at the upper driver stage of M1 are not needed at the input of the transformer T of the M2 lower side driver.

The proposed driver topology operates suitably at high frequencies, for instance up to 27MHz with a peak current of 80A and DC-Bus voltage of 120V.

Having described the invention with regard to certain specific embodiments, it is to be understood that these embodiments are not meant as limitations of the invention. Indeed, various modifications, adaptations and/or combination between embodiments may become apparent to those skilled in the art without departing from the scope of the annexed claims. In particular, it is to note that the proposed driver topology can be transferred and applied to any switching amplifier topologies, where floating gate drives are needed.

## Claims

1. Driver topology for switching on and off a high voltage floating gate-source (G1-S1) of a MOSFET (M1), wherein it comprises a grounded driving amplifier (U) connected with decoupling capacitors (C1, C2) connected in series with inputs of a common mode transformer (T) connected at its output to a rectifying diode and stabilizing resistor (D, R), whereby the diode and the resistor are connected in parallel between the gate and the source of the MOSFET **characterized in that** said common mode transformer transmits at one end the energy coming from said decoupling capacitors to said rectifying diode and stabilizing resistor and blocks the reverse flow at the other end.

2. Driver topology according to claim 1, wherein it further comprises a half DC-bus voltage connected to the input of the current mode transformer.

3. Driver topology according to claim 1 or 2, wherein the common mode transformer is implemented by a current mode 1:1 balun or a transmission line.

4. Driver topology according to any of claims 1 to 3, wherein it has a totem-pole configuration of two MOSFETs (M1, M2), the high voltage floating gate-source (G1-S1) being representative of the high side, and wherein the low side driver topology comprises similar signal delay means as the high side driver topology.

5. Driver topology according to claim 4, wherein the low side driver topology comprises a grounded driving amplifier (U) connected with a common mode transformer (T) connected at its output to a rectifying diode and a stabilizing resistor (D, R) whereby the diode and the resistor are connected in parallel between the gate and the source of the low side MOSFET (M2).

6. A high integrated circuit including both the driver topology according to any of the preceding claims and the MOSFET.

7. High frequency ignition system comprising a MOSFET and a driver topology according to any of claims 1 to 6.

## Patentansprüche

1. Treibertopologie zum Ein- und Ausschalten einer Hochspannungs-Floating-Gate-Source (G1-S1) eines MOSFETs (M1), die einen geerdeten Treiberverstärker (U) aufweist, verbunden mit Entkopplungskondensatoren (C1, C2), verbunden in Serie mit Eingängen eines Gleichtakt-Transformators (T), der an seinem Ausgang mit einer Gleichrichterdiode und einem Stabilisierungswiderstand (D, R) verbunden ist, wobei die Diode und der Widerstand parallel zwischen dem Gate und der Source des MOSFETs verbunden sind, **dadurch gekennzeichnet, dass** der Gleichtakt-Transformator an einem Ende die Energie, die von den Entkopplungskondensatoren kommt, an die Gleichrichterdiode und den Stabilisierungswiderstand überträgt und den Rückstrom an dem anderen Ende blockiert.

2. Treibertopologie gemäß Anspruch 1, die weiter eine Halb-DC-Busspannung aufweist, die mit dem Eingang des Strom-Modus-Transformators verbunden ist.

3. Treibertopologie gemäß Anspruch 1 oder 2, wobei der Gleichtakt-Transformator durch einen Strom-Modus-1: 1-Balun oder eine Übertragungsleitung implementiert ist.

4. Treibertopologie gemäß einem der Ansprüche 1 bis 3, die eine Totempfahl-Konfiguration von zwei MOSFETs (M1, M2) hat, wobei die Hochspannungs-Floating-Gate-Source (G1-S1) repräsentativ ist für die hohe Seite, und wobei die Treibertopologie der niedrigen Seite ähnliche Signalverzögerungsmittel aufweist wie die Treibertopologie der hohen Seite.

5. Treibertopologie gemäß Anspruch 4, wobei die Treibertopologie der niedrigen Seite einen geerdeten Treiberverstärker (U) aufweist, verbunden mit einem Gleichtakt-Transformator (T), der an seinem Ausgang mit einer Gleichrichterdiode und einem Stabilisierungswiderstand (D, R) verbunden ist, wobei die Diode und der Widerstand parallel zwischen dem Gate und der Source des MOSFETs (M2) der niedrigen Seite verbunden sind.

6. Eine hoch-integrierte Schaltung, die sowohl die Treibertopologie gemäß einem der vorhergehenden Ansprüche als auch den MOSFET umfasst.

7. Hochfrequenzzündsystem, das einen MOSFET und eine Treibertopologie gemäß einem der Ansprüche 1 bis 6 aufweist.

## Revendications

1. Topologie de commande pour mettre en marche et arrêter une source haute tension à grille flottante (G1-S1) d'un MOSFET (M1), comportant un amplificateur (U) d'attaque mis à la terre relié à des condensateurs (C1, C2) de découplage reliés en série à des entrées d'un transformateur (T) de mode commun relié à sa sortie à une diode de redressement et une résistance stabilisatrice (D, R), la diode et la résistance étant branchées en parallèle entre la grille et la source du MOSFET, **caractérisé en ce que** ledit transformateur de mode commun transmet à une extrémité l'énergie provenant desdits condensateurs de découplage à ladite diode de redressement et à ladite résistance stabilisatrice et bloque la circulation inverse à l'autre extrémité.

2. Topologie de commande selon la revendication 1, comportant en outre une demi-tension de bus à courant continu reliée à l'entrée du transformateur de mode commun.

3. Topologie de commande selon la revendication 1 ou 2, le transformateur de mode commun étant mis en oeuvre par un symétriseur 1:1 en mode courant ou une ligne de transmission.

4. Topologie de commande selon l'une quelconque des revendications 1 à 3, dotée d'une configuration "totem-pole" de deux MOSFET (M1, M2), la source haute tension à grille flottante (G1-S1) étant représentative du côté haut et la topologie de commande du côté bas comportant des moyens de retard de signal similaires à ceux de la topologie de commande côté haut.

5. Topologie de commande selon la revendication 4, la topologie de commande du côté bas comportant un amplificateur (U) d'attaque mis à la terre relié à un transformateur de mode commun (T) relié à sa sortie à une diode de redressement et à une résistance stabilisatrice (D, R), la diode et la résistance étant branchées en parallèle entre la grille et la source du MOSFET côté bas (M2).

6. Circuit hautement intégré comprenant à la fois la topologie de commande selon l'une quelconque des revendications précédentes et le MOSFET.

7. Système d'allumage à haute fréquence comportant un MOSFET et une topologie de commande selon l'une quelconque des revendications 1 à 6.
